(19) **Europäisches Patentamt**

**European Patent Office**

**Office européen des brevets**

(11) **EP 0 752 769 A1**

## (12) EUROPEAN PATENT APPLICATION

(43) Date of publication:
08.01.1997 Bulletin 1997/02

(51) Int. Cl.$^6$: **H04L 1/24**, H04L 1/20, H04L 1/00, H03M 13/00

(21) Application number: 96201852.9

(22) Date of filing: 04.07.1996

(84) Designated Contracting States:
AT BE CH DE DK ES FI FR GB GR IE IT LI LU NL PT SE

(30) Priority: 06.07.1995 NL 1000743

(71) Applicant: Koninklijke PTT Nederland N.V.
2509 CH Den Haag (NL)

(72) Inventor: Byun, Kuen Soo
2545 ES Den Haag (NL)

(74) Representative: van Bommel, Jan Peter et al
Koninklijke PTT Nederland N.V.,
P.O. Box 95321
2509 CH Den Haag (NL)

(54) **Bit error rate monitoring in receiver with error correction**

(57) Bit error rate (BER) measurement in a receiver in which digital codes are received and decoded which, at the transmitter end, are encoded into codewords which comprise information and check symbols. On decoding at the receiver end, correction of any erroneous codewords takes place. Since the correction is unsuccessful in only a negligible number of cases, the BER can be determined on the basis of the ratio of the number (c) of symbol corrections and the number (r) of received symbols, which may be equated to the symbol error ratio before decoding ($SER_{before}$). Said ratio (c/r) is derived from the decoder by an arithmetic unit (1). A conversion unit (2) converts the ratio (c/r) into a post-decoding symbol error rate ($SER_{after}$). A second arithmetic unit converts this into the required BER.

FIG. 2

## Description

A. BACKGROUND OF THE INVENTION

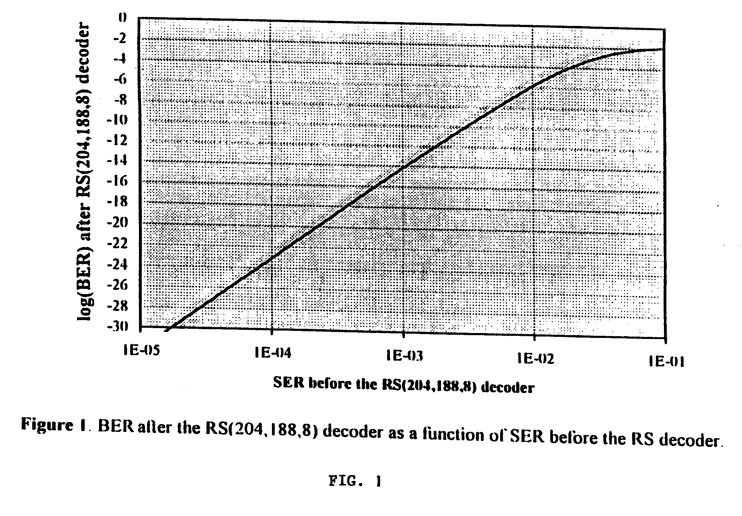

The invention relates to the determination of the bit error rate in a receiver in which digital signals are received and decoded which, at the transmitter end, are encoded into codewords which comprise information and check symbols. During decoding at the receiver end, a limited number of erroneously received symbols per codeword are corrected. The maximum number of correctable symbols per codeword is dependent upon the encoding method used. A system in which the invention is applicable, is shown inter alia in FIG. 1 of the ETSI Standard ETS 300429. Therein a digital cable television system is shown in which forward error correction is applied. In this connection, according to the prior art, use is made of a Reed-Solomon (RS) encoder in which the information to be transmitted is encoded into a codeword with a generator polynomial. At the receiver end, any erroneous symbols are corrected in an RS decoder. The system discussed must work on a Quasi Error Free (QEF) basis, that is to say, a maximum of 1 bit error per hour is allowed to occur. This is equivalent to a Bit Error Rate (BER) of less than approx. $10^{-11}$ at a transmission bit rate of 40 Mb/s. Through this requirement the need makes itself felt to be able to measure in practice, either periodically or continuously, the real BER.

The measurement of the BER of such a digital system by means of a conventional measuring method, in which a test signal is used, has the following two important disadvantages:

I. For the injection of a test signal the system must be put out of operation;
II. In practice, the BER measurement takes an unacceptable amount of time (for the detection of one bit error one must, on average, wait 1 hour (see the definition of QEF).

B. SUMMARY OF THE INVENTION

The invention is based on the insight that, when using a decoder with powerful error-correcting properties in its operational range, the number of unsuccessful symbol corrections is negligible compared to the number of symbol corrections which are indeed successful, as a result of which the number of symbol corrections which are carried out by the decoder can be used as a measure for the required BER.

For example, an RS (204,188,8) decoder is able to reduce an error probability of $10^{-4}$ in the bit stream presented to the receiver to $10^{-11}$ bits (in other words from $10^7/10^{11}$ to $1/10^{11}$): a factor of $10^7$. Per $10^{11}$ received bits the decoder is thus able to successfully correct $10^7$ bit errors, not more than one bit 'failing'.

According to the invention, use can therefore be successfully made of information which can be derived from the decoder in a simple way, namely of the number of symbol corrections which the decoder carries out. That number of corrections, related to the number of symbols received, can be simply converted into the required BER value. One thing and another can be clarified as follows:

1. The relationship between the BER and the SER is: $1-SER=(1-BER)^m$, where m is the number of bits per symbol. If the BER«1, as is the case here also (since BER<$10^{-11}$), then it holds that:

$$BER_{after} \approx \frac{SER_{after}}{m}$$

2. The symbol error rate (SER) after the RS decoder ($SER_{after}$) as a function of the symbol error rate (SER) before the RS decoder ($SER_{before}$) is equal to

$$SER_{after} \approx \frac{1}{n}\sum_{i=1+t}^{n} i\binom{n}{i}(SER_{before})^{i}(1-SER_{before})^{(n-i)}$$

where n is the number of symbols per codeword and t is the number of correctable symbols per codeword. A graphical elaboration of this formula is shown in FIG. 1.

Thus on the basis of the pre-decoder SER ($SER_{before}$), the post-decoder SER ($SER_{after}$) can be determined.

3. The $SER_{before}$ cannot be directly derived from the decoder. However, since the $SER_{after}$ with respect to the $SER_{before}$ is negligibly small due to the powerful correction properties of the decoder, the $SER_{before}$ can be equated with the number of symbols corrected by the decoder for the number of symbols received, both of which variables can indeed be derived from the decoder in a technically simple manner.

As a result, in the reverse order of the foregoing points, the ratio between the number of symbols corrected by the decoder and the number of symbols received by the decoder can be detected. The value of that ratio may be equated with the $SER_{before}$. The $SER_{before}$ can, according to a prior-art operation, be converted into a value for $SER_{after}$, which ultimately can be converted into the required $BER_{after}$ value.

## C. <u>EXAMPLE OF EMBODIMENT</u>

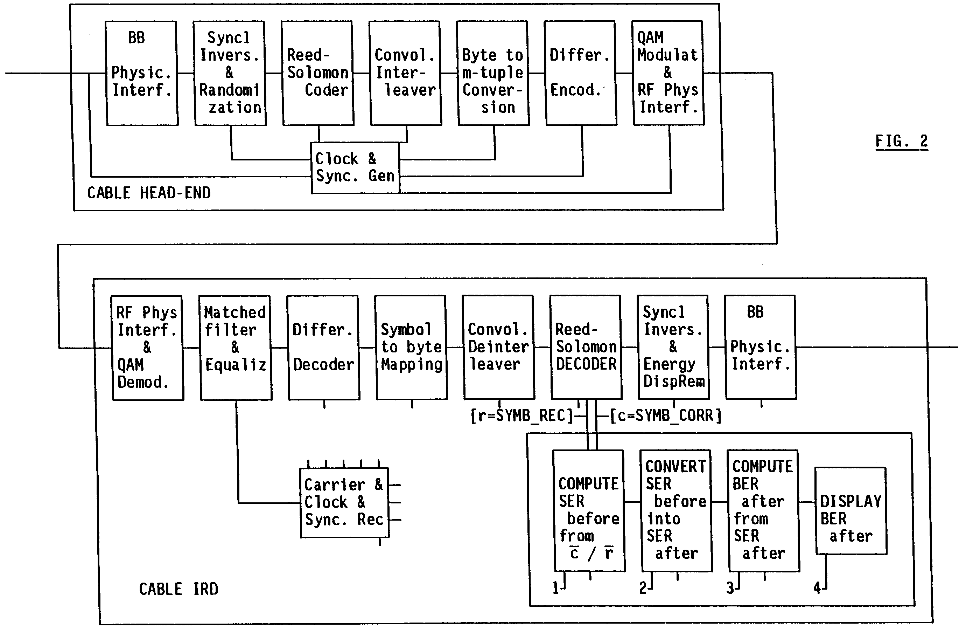

FIG. 2 diagrammatically shows a Cable Headend at the transmitter end and a Cable IRD, hereinafter referred to as receiver, connected thereto via a cable. The figure is largely identical to FIG. 1 of ETSI Standard ETS 300429. The operation and inter-relationship are explained in said Standard.

The RS encoder at the transmission end encodes the information to be transmitted into codewords comprising information symbols and check symbols, with which at the receiver end almost all errors , for example transmission errors, are corrected.

In a technically simple manner, a signal pulse r can be derived from the RS decoder for each symbol received by the RS decoder, as well as a signal pulse c for each symbol correction which was successfully carried out by the decoder. In FIG. 2 said pulses r and c are presented to an arithmetic unit 1, which, by means of counters, adds the number of c pulses and r pulses over a certain time and divides the one by the other $(\overline{c} / \overline{r})$. The arithmetic unit 1 can process the pulses received according to a 'jumping window', in which continually, after a certain period, the number of c pulses are divided by the number of r pulses and the counters are reset. Another possibility is processing according to a 'moving window', in which each clock pulse (or once per x clock pulses) the number of c pulses and the number of r pulses during the foregoing period of time (of y clock pulses) are divided by each other.

The value thus calculated by the arithmetic unit 1 for $SER_{before}$ $(= \overline{c} / \overline{r})$ is presented to a convertor 2. In said convertor, the presented $SER_{before}$ value is converted into the correct $SER_{after}$ value. This conversion can be carried out by means of a microprocessor, included in said convertor, which calculates the $SER_{after}$ value from the presented $SER_{before}$ value according to the formula discussed above

$$SER_{after} \approx \frac{1}{n} \sum_{i=1+t}^{n} i \binom{n}{i} (SER_{before})^{i} (1 - SER_{before})^{(n-i)}$$

Another possibility is providing the convertor 2 with a conversion table for $SER_{before}$ and $SER_{after}$, as shown in FIG. 1. Said table is then addressed by the value $SER_{before}$ received from the arithmetic unit, after which the corresponding $SER_{after}$ value is read out.

The $SER_{after}$ value obtained by the convertor 2 is subsequently presented to an arithmetic unit 3 which divides this value by the number (m) of bits per symbol ($BER_{after} = SER_{after} / m$) and presents said $BER_{after}$ value, for example, to a display unit 4.

## D. <u>REFERENCES</u>

ETSI Standard ETS300429 "Digital broadcasting systems for television, sound and data services; Framing structure, channel coding and modulation; Cable systems", Dec. 1994

**Claims**

1.   Method for the determination of the bit error rate in a receiver in which digital signals are received and decoded which, at the transmitter end, are encoded into codewords which comprise information symbols and check symbols, any erroneous codewords being corrected in the receiver, <u>characterised in that</u> the ratio between the number of corrected symbols (c) and the number of symbols received (r) is taken as the measure for the bit error rate ($BER_{after}$).

2.   Receiver for receiving and, in a decoding unit, decoding codewords which comprise information symbols and check symbols , said decoding unit correcting any erroneous codewords, <u>characterised by</u> a computing unit (1) for computing the ratio between the number (c) of the symbols corrected by the decoding unit and the number (r) of the symbols received by said decoding unit, and conversions means (2,3) for converting the ratio calculated by the computing unit into a bit error rate.

3.   Receiver according to Claim 2, <u>characterised in that</u> the computing unit (1) carries out said operation according to a "jumping window", in which, during a staggered time interval and by means of counters, the number (c) of symbol corrections and the number (r) of received symbols are summed and in which the summed numbers, at the end of each time interval, are divided by each other and the result is passed on to the conversion means, after which the counters are reset.

4. Receiver according to Claim 2, <u>characterised in that</u> the computing unit (1) carries out said operation according to a "moving window", in which over a progressive time interval the number (c) of symbol corrections and the number (r) of received symbols are summed, and the summed numbers are divided by each other and the result is passed on to the conversion means.

5. Receiver according to Claim 2, <u>characterised in that</u> the conversion unit (2) is a computing unit which, on the basis of the ratio calculated by the computing unit (1) already mentioned and of an algorithm, calculates the post-decoding symbol error rate ($SER_{after}$), said symbol error rate being converted into the required bit error rate ($BER_{after}$) by a second computing unit (3).

6. Receiver according to Claim 2, <u>characterised in that</u> the conversion unit (2) is provided with a conversion table containing, on the one hand, values for the ratio (c/r) supplied by the computing unit (1), and, on the other, values for the symbol error rate ($SER_{after}$), said symbol error rate being converted into the required bit error rate ($BER_{after}$) by a second computing unit (3).

Figure 1. BER after the RS(204,188,8) decoder as a function of SER before the RS decoder.

FIG. 1

5

FIG. 2

CABLE HEAD-END

Blocks: BB Physic. Interf. | Syncl Invers. & Randomization | Reed-Solomon Coder | Convol. Inter-leaver | Byte to m-tuple Conver-sion | Differ. Encod. | QAM Modulat & RF Phys Interf.

Clock & Sync. Gen

CABLE IRD

Blocks: RF Phys Interf. & QAM Demod. | Matched filter & Equaliz | Differ. Decoder | Symbol to byte Mapping | Convol. Deinter leaver | Reed-Solomon DECODER | Syncl Invers. & Energy DispRem | BB Physic. Interf.

[r=SYMB_REC] — —[c=SYMB_CORR]

Carrier & Clock & Sync. Rec

COMPUTE SER before from $\bar{c} / \bar{r}$   1

CONVERT SER before into SER after   2

COMPUTE BER after from SER after   3

DISPLAY BER after   4

EP 0 752 769 A1

European Patent Office

**EUROPEAN SEARCH REPORT**

Application Number

EP 96 20 1852

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | EP-A-0 472 175 (NEC CORPORATION) 26 February 1992<br>* page 2, line 5 - line 41 *<br>* page 4, line 5 - page 5, line 11 *<br>* claims *<br>--- | 1-6 | H04L1/24<br>H04L1/20<br>H04L1/00<br>H03M13/00 |
| A | GB-A-2 276 297 (N.V. PHILIPS' GLOEILAMPENFABRIEKEN) 21 September 1994<br>* page 1, line 4 - page 3, line 4 *<br>* page 6, line 25 - line 27 *<br>* page 7, line 6 - line 13 *<br>--- | 1-6 | |
| A | US-A-4 920 537 (DARLING ET AL.) 24 April 1990<br>* abstract; figure 4 *<br>* column 1, line 50 - column 2, line 48 *<br>* column 4, line 24 - column 5, line 36 *<br>--- | 1-6 | |
| A | EP-A-0 179 465 (NEC CORPORATION) 30 April 1986<br>* abstract *<br>* page 9, line 12 - page 12, line 9 *<br>* figures 1,3 *<br>--- | 1-6 | |
| A | 41ST IEEE VEHICULAR TECHNOLOGY CONFERENCE VTC '91, 19-22 MAY 1991, ST. LOUIS, US, 1991, IEEE, NEW YORK, US, pages 543-548, XP000260236 K.G. CORNETT ET AL.: "Bit error rate estimation techniques for digital land mobile radios"<br>* abstract *<br>* page 543, left-hand column, paragraph 3 *<br>* page 546, paragraph IV - page 548, paragraph 1 *<br>----- | 1-6 | |

**TECHNICAL FIELDS SEARCHED (Int.Cl.6)**

H04L
H03M

The present search report has been drawn up for all claims

| Place of search | Date of completion of the search | Examiner |
|---|---|---|
| THE HAGUE | 5 November 1996 | Gries, T |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)